Europäisches Patentamt

**European Patent Office**

**Office européen des brevets**

(11) Veröffentlichungsnummer: **0 062 833**

**A1**

(12) **EUROPÄISCHE PATENTANMELDUNG**

(21) Anmeldenummer: **82102677.0**

(22) Anmeldetag: **30.03.82**

(51) Int. Cl.³: **G 01 R 1/073**
G 01 R 31/28, H 01 R 11/18

(30) Priorität: **02.04.81 DE 3113375**

(43) Veröffentlichungstag der Anmeldung:
**20.10.82 Patentblatt 82/42**

(84) Benannte Vertragsstaaten:
**FR GB IT SE**

(71) Anmelder: **SIEMENS AKTIENGESELLSCHAFT Berlin und München**
**Postfach 22 02 61**
**D-8000 München 22(DE)**

(72) Erfinder: **Kienapfel, Bernd**
**Brandenburger Strasse 86**
**D-8901 Königsbrunn(DE)**

(72) Erfinder: **Merkenschlager, Hans-Hermann**
**Spielfeldstrasse 15**
**D-8900 Augsburg(DE)**

(54) Adaptereinrichtung und Verfahren zur elektrischen Verdrahtungsprüfung von unbestückten Leiterplatten.

(57) Bei der Verdrahtungsprüfung von Leiterplatten ist es vorteilhaft, daß für unterschiedliche unbestückte Leiterplattentypen eine universelle Prüfvorrichtung zur Verfügung steht, wobei die Umrüstung auf den jeweils zu prüfenden Typ rasch und unproblematisch vor sich gehen soll.

Hierzu wird eine Adaptiereinrichtung mit einem zwischen einer beweglichen Andruckplatte (2) und einer beweglichen Leiterplattenaufnahme (6) befindlichen Zwischenrahmen (1) vorgesehen, der seitlich in einem festen Raster Wrapstifte (14) zur Kontaktierung mit Adapternadeln (12) eines feststehenden Adapternadelfeldes und mittig an Wrapstiften (15) befestigte Prüfadapternadeln (13) enthält, wobei entsprechend der Prüfanforderungen die beiden Arten von Wrapstiften (14, 15) mit einer Wrapverdrahtung (10) verbunden sind. Der Prüfvorgang erfolgt dadurch, daß zunächst die seitlichen Wrapstifte 14 des Zwischenrahmens (1) durch dessen Absenkung mit den Adapternadeln (12) des Standardadapternadelfeldes (8) und anschließend die Prüfpunkte auf der Prüflingsleiterplatte (7) durch Anheben an die Prüfadapternadeln (13) angepreßt werden, so daß Prüfverbindungen mit einem Prüfautomaten hergestellt sind. Die Adaptiereinrichtung ist insbesondere für die Prüfung von Leiterplatten in der Datentechnik geeignet.

FIG 1

SIEMENS AKTIENGESELLSCHAFT      Unser Zeichen

Berlin und München               VPA 81 P 2 0 2 1 E

## Adaptiereinrichtung und Verfahren zur elektrischen Verdrahtungsprüfung von unbestückten Leiterplatten.

Die Erfindung betrifft eine Adaptiereinrichtung zur elektrischen Verdrahtungsprüfung von unbestückten Leiterplatten mit einem die Kontaktelemente tragenden Adapter und einer gegen den Adapter bewegbaren Leiterplattenaufnahme.

Sie betrifft außerdem ein Verfahren zur elektrischen Verdrahtungsprüfung von unbestückten Leiterplatten mit einer Adaptiereinrichtung.

Eine bekannte Adaptiereinrichtung besteht aus mehreren übereinander geschichteten und miteinander fest verbundenen Kunststoffplatten, in denen entsprechend der jeweiligen Prüflingskonfiguration Adapternadeln angeordnet sind, die über einen Drahtanschluß mit dem Prüfautomaten verbunden sind. Bei dieser Anordnung dient der aus Einzelplatten aufgebaute Nadelträger auch zur Aufnahme deer Adaptierkräfte. Der Kraftfluß zeigt, daß die Kräfte, die beim Kontaktieren von jeder einzelnen Adapternadel verursacht werden, durch den Nadelträger hindurch auf den außen liegenden Grundrahmen übertragen werden. Um eine Durchbiegung des Nadelträgers zu verhindern, müssen entsprechende Abstützungen zur Versteifung vorgenommen werden, die die Freizügigkeit der Anordnung von Prüfpunkten auf den Leiterplatten beeinträchtigen können. Außerdem muß die mehrfach geschichtete Kunststoffplatte äußerst massiv sein, da jede Adapternadel eine Federkraft von ca. 150 Pond besitzt, die notwendig ist, um bei der Kontaktierung einen möglichst geringen Übergangwiderstand zu erhalten. Bei einem Nadelfeld mit z. B. 5000 Nadeln addieren sich die Einzelkräfte zu ca. 750 Kilopond. Die Größenordnung von

Zk 1 Fdl/1. 4. 1981

einigen 100 Kilopond zeigt, daß eine massive Bauweise
mit hohem Kostenaufwand erforderlich ist. Zudem sind derartige Nadelträger durch das hohe Gewicht unhandlich und
eine Umrüstung des Adapters und der Prüflinge sehr aufwendig. Für verschiedene zu prüfende Leiterplattentypen
kann es notwendig sein, individuelle Prüfadater zu verwenden. Die Anschaltung an den Prüfautomaten erfolgt
durch 96 oder 128-polige Verbindungskabel mit Steckverbindern. Beim Umrüsten des Prüfadapters auf einen anderen Leiterplattentyp müssen daher die Nadelträger ausgewechselt werden. Das bedeutet, daß vor dem Auswechseln
alle Verbindungsleitungen abgesteckt werden müssen. Nach
dem Einsetzen des neuen Nadelträgers müssen diese Verbindungsleitungen in der richtigen Reihenfolge wieder
angeschlossen werden. Diese Arbeiten sind mit großem
Zeitaufwand verbunden.

Aufgabe der vorliegenden Erfindung ist es, eine Adaptiereinrichtung anzugeben, die auf den jeweils zu prüfenden
Leitertyp rasch umrüstbar ist. Außerdem soll ein Verfahren
angegeben werden, das mit einem derartigen Adapter ein
zeitsparendes Prüfverfahren ermöglicht.

Zur Lösung dieser Aufgaben wird gemäß der Erfindung die
Adaptiereinrichtung derart ausgebildet, daß der Adapter
aus einem Zwischenrahmen besteht, der zwischen einer Andruckplatte und der Leiterplattenaufnahme beweglich angeordnet ist, daß mindestens auf einer Seite der Leiterplattenaufnahme ein feststehendes Standardnadelfeld angeordnet ist, das eine für die Prüfung unterschiedlicher
Leiterplattenkonfigurationen ausreichende Anzahl von
Adapternadeln enthält, an die die erforderlichen Prüfleitungen angelegt sind, daß der Zwischenrahmen aus einer
Abdeckplatte, einer Trägerplatte und einer Führungsplatte
besteht, daß die Trägerplatte in ihren Randbereichen in
festen Rastern angeordnete Wrapstifte enthält, die mit
den Adapternadeln kontaktierbar sind, daß die Trägerplatte im Leiterplattenprüflingsbereich weitere in einem leiterplattenprüflingsbezogenen Raster angeordnete Wrapstifte aufweist, die mit in einer Führungsplatte befestigten Prüflingsadapternadeln fest verbunden sind, daß zwischen den Wrapstiften für das Standardnadelfeld und den Wrapstiften für den Prüflingsbereich eine für den speziellen Leiterplattenprüfling angepaßte Verdrahtung vorgesehen ist, daß die Abdeckplatte den Anschlag für die Wrapstifte auf der Verdrahtungsseite bildet, und daß der Leiterplattenprüfling auf der Leiterplattenprüflingsaufnahme befestigt ist.

Durch diese Maßnahmen ist es lediglich notwendig, bei der Prüfung unterschiedlicher Leiterplattentypen jeweils den entsprechenden Zwischenrahmen auszuwechseln. Die beim Kontaktieren der Nadeln verursachte Kraft wird bei dieser Konstruktion auf den senkrecht angeordneten Wrapstift übertragen und durch die darüber liegende Andruckplatte abgefangen. Der äußere Grundrahmen und der Zwischenrahmen bleiben außerhalb des Kraftflusses und haben nur noch Prüfungsfunktionen. Als Folge davon ist ein wesentlich leichterer Aufbau möglich, der zugleich auch kostengünstiger ist. Das bisher zeitaufwendige Umrüsten bei der Verwendung von konventionellen Steckverbindern wird durch die Anwendung des Anmeldungsgegenstandes vermieden.

Das Verfahren zur elektrischen Verdrahtungsprüfung von unbestückten Leiterplatten sieht dabei vor, daß in einem ersten Schritt die Andruckplatte gegen den Zwischenrahmen gedrückt wird, so daß dessen seitlichen Wrapstifen mit den Adapternadeln des Standardnadelfeldes kontaktiert werden, und daß in einem zweiten Schritt durch eine entgegengesetzte Bewegung der Leiterplattenprüflingsaufnahme mit dem Leiterplattenprüfling gegen die Spitzen der Prüflingsadapternadeln gedrückt wird, und daß in einem dritten Schritt die Funktionsprüfung des Leiterplattenprüflings über einen mit dem Standardnadelfeld verbundenen Prüfautomaten erfolgt.

Aus dem Arbeitsablauf ist ersichtlich, daß keine manuelle Betätigung von Steckverbindungen mehr notwendig ist. Die Kontaktierung erfolgt selbsttätig bei Ausführung des Arbeitshubes durch die obere Andruckeinheit.

Anhand des Standes der Technik nach Fig. 1 sowie der Ausführungsbeispiele der Erfindung nach den Figuren 2 bis 5 wird die Erfindung näher erläutert.

Es zeigen:

Fig. 1 eine bekannte Adaptiereinrichtung,

Fig. 2 einen Ausschnitt aus dem Prüflingsteil des Zwischenrahmens nach der Erfindung,

Fig. 3 eine schematische Darstellung der Adaptiereinrichtung,

Fig. 5 den Arbeitsablauf des Verfahrens.

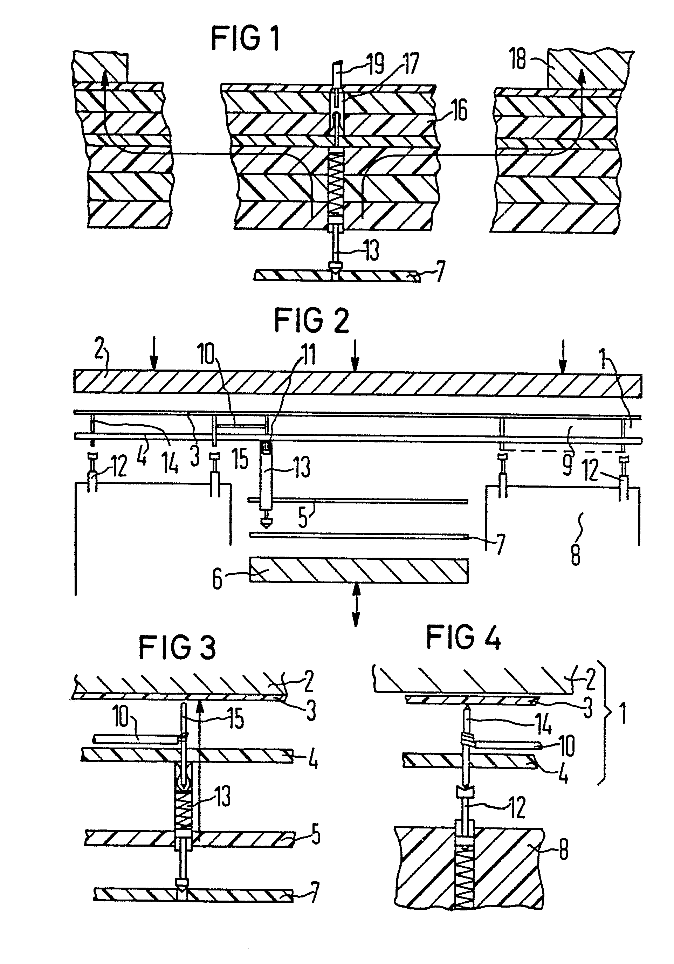

Die Fig. 1 zeigt einen Ausschnitt aus einer bekannten Adaptiereinrichtung. Der Nadelträger 16 ist aus mehreren Kunststoffplatten in Sandwichbauweise zusammengesetzt. Die einzelnen übereinandergeschichteten Platten sind erforderlich, um die notwendigen Bohrgenauigkeiten einhalten zu können. Die Adapternadeln 13 sind dabei entsprechend der Schaltungskonfiguration des Leiterplattenprüflings angeordnet. Eine Adapternadel 13 besteht dabei aus einer Spitze zum Kontaktieren mit dem jeweiligen Prüfpunkt des Leiterplattenprüflings 7. Die Nadelspitze ist federnd gelagert und läuft in einen Stift 17 aus, der wiederum von einem Kontakt 18 umfaßt wird, an dem dann der Drahtanschluß 19 befestigt ist. Bei der Prüfung wird die Prüflingsleiterplatte 7, die auf einer Leiterplattenaufnahme, die im Bild nicht dargestellt ist, liegt, gegen die Adapternadeln 13 gepreßt und die auftretenden Kräfte müssen, wie der in Fig. 1 eingetragene Kraftfluss zeigt, von dem Nadelträger 16 und dem in der Maschine befindlichen Grundrahmen 18 abgefangen werden. Da der Nadelträger die gesamten auftretenden Kräfte aufnehmen muß, ist es notwendig, daß er äußerst stabil aufgebaut ist. Gleichzeitig muß für jede Leiterplattentype ein entsprechender Nadelträger angefertigt werden.

Eine Adaptiereinrichtung nach der Erfindung ist in Fig. 2 gezeigt. Der Nadelträger besteht dabei aus einem Zwischenrahmen 1, der seinerseits wieder eine Abdeckplatte 3, eine Trägerplatte 4 und eine Führungsplatte 5 enthält. An den beiden Seiten der Adaptereinrichtung sind feststehende Standardnadelfelder 8 vorgesehen, die Adapternadeln 12 enthalten, die wiederum an ihrer einen Anschlußseite mit entsprechenden Prüfleitungen, die zu einem Prüfautomaten führen, angeschlossen sind. Im Standardnadelfeld 8 sind dabei soviele Adapternadeln angeordnet, wie für die unterschiedlichen Leiterplattentypen Prüfpunkte erforderlich sind.

In der Trägerplatte 4 des Zwischenrahmens sind in den seitlichen Bereichen entsprechend dem Raster der Adapternadeln 12 des Standardnadelfeldes 8 Wrapstifte 14 angeordnet, die mit den Adapternadeln 12 kontaktierbar sind. Im Mittelteil der Trägerplatte sind außerdem weitere Wrapstifte 15 vorgesehen, die mit den Prüflingsadapternadeln 13 verbunden sind. Die Prüflingsadapternadeln 13 werden von einer Führungsplatte 5 gehalten. Sie dienen dazu, die Prüfpunkte auf der Prüfleiterplatte 7 während des Prüfvorgangs zu kontaktieren. Die Wrapstifte 14 und die Wrapstifte 15 sind entsprechend der jeweiligen Leiterplattenkonfiguration und der entsprechenden Prüfpunkte, die angesteuert werden müssen, mit einer speziellen Wrapverdrahtung verbunden. Oberhalb des Zwischenrahmens 1 ist eine Andruckplatte 2 vorgesehen, die sich in Pfeilrichtung bewegt und dadurch auf den Zwischenrahmen 1 drückt und diesen mit den Adapternadeln 12 des Standardnadelfeldes 8 kontaktiert. Die Prüflingsleiterplatte 7 liegt auf einer Leiterplattenaufnahme 6 und kann ebenfalls nach oben und unten bewegt werden, so daß sie an vorgegebenen Prüfpunkten mit der Adapternadeln 13 verbindbar ist.

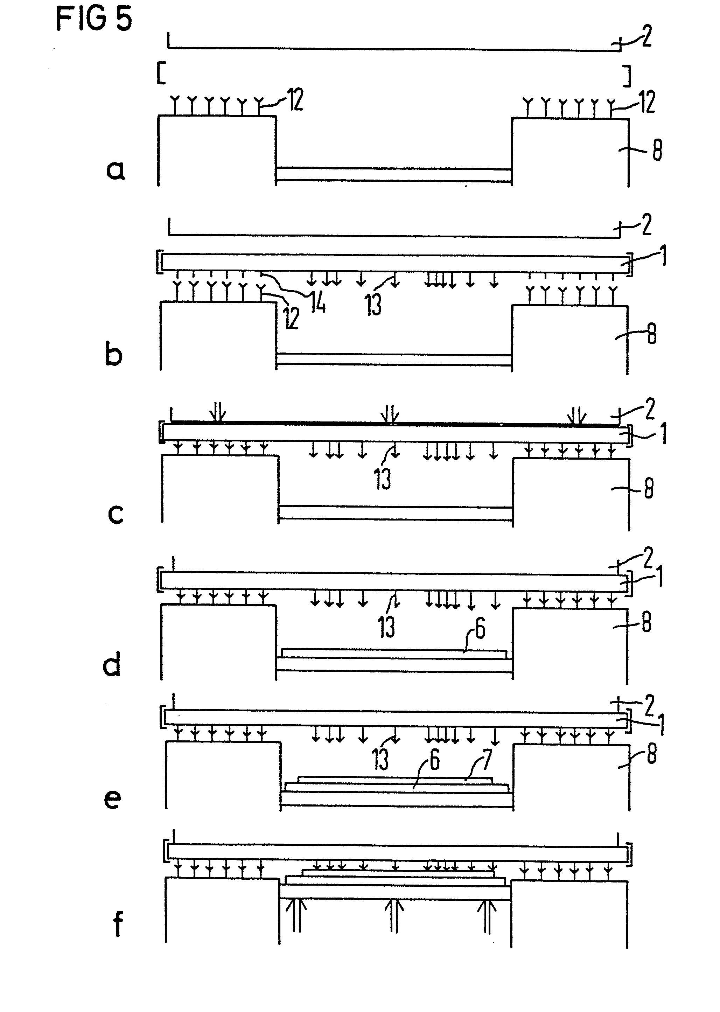

Eine detaillierte Ansicht einer Adapternadel im Prüflingsbereich des Zwischenrahmens zeigt Fig.4 . Die Adapternadel
13 ist in der Führungsplatte 5 gehalten. Sie weist an
ihrem oberen Ende einen Kontakt auf, in den ein Wrapstift
15 eingreift und dort fest umschlossen wird. Die Wrapstifte 15 finden auf der gegenüberliegenden Seite einen
Anschlag durch die Deckplatte 3. Von ihnen weg führt die
Wrapverdrahtung 10 zu den Wrapstiften 14 im äußeren Bereich des Zwischenrahmens 1. Die Adapternadel 13 greift
mit ihrer Spitze in eine vorgesehene Bohrung der Prüflingsleiterplatte 7 ein und kontaktiert diese dadurch mit dem
Prüfautomaten. Die beim Kontaktieren der Nadel verursachte
Kraft wird, wie in der Figur eingezeichnet, auf den senkrecht angeordneten Wrapstift übertragen und durch die
darüberliegende Andruckplatte 2 abgefangen. Der äußere
Grundrahmen und der gesamte Zwischenrahmen 1 bleiben außerhalb des Kraftflusses und haben nur noch Führungsfunktionen.

Fig. 3 zeigt einen Ausschnitt aus einem Randbereich des
Zwischenrahmens 1. Das Standardnadelfeld 8 enthält in
einem bestimmten vorgegebenen Raster Adapternadeln 12.
Im gleichen Raster sind in der Trägerplatte 4 des Zwischenrahmens 1 Wrapstifte 14 angeordnet, die mit den Adapternadeln 12 kontaktierbar sind. Auf der gegenüberliegenden
Seite der Wrapstifte bildet die Deckplatte 3 wieder eine
Anschlagfläche und oberhalb der Deckplatte 3 ist die
Andruckplatte 2 gezeigt. Die Wrapverdrahtung 10 führt
zu den Wrapstiften 15, wie sie in der Fig. 4 dargestellt
sind. Die Wrapstifte 14 dienen also einerseits als Ausgangspunkt für die Verdrahtung des Zwischenrahmens 1,
andererseits werden sie als Kontaktierungspunkte für
das Standardnadelfeld 8, das in der Grundeinheit des
Adapters angeordnet ist, verwendet.

Der Umrüstaufwand des Prüfsystems auf einen anderen
Prüflingstyp beschränkt sich auf folgende Arbeitsgänge:

1. Obere Andruckpneumatik betätigen (Andruckplatte 2 wird nach oben bewegt, Kontaktierung des Standardnadelfeldes 8 wird unterbrochen,

2. Zwischenrahmen 1 entriegeln,

3. Zwischenrahmen für Leiterplattentyp eins von Bedienungsseite aus entnehmen,

4. Zwischenrahmen Leiterplattentyp zwei von Bedienungsseite aus einlegen,

5. Zwischenrahmen verriegeln,

6. oberene Andruckpneumatik betätigen, Andruckplatte 2 wird nach unten bewegt, Kontaktierung zwischen Wrapfeld mit den Wrapstiften 14 und dem Standardnadelfeld 8 wird hergestellt.

Durch die Konstruktion nach der Erfindung kann der Zwischenrahmen aus standardisierten Teilen bestehen und eine Mehrfachverwendung vorgesehen werden. Der Rahmen ist dabei aus Leichtbauweise mit Aluprofilen herstellbar. Die Adapternadeln sind in steckbarer Ausführung gefertigt. Dabei können Wrapstifte für Miniwraptechnik eingesetzt werden. Um einen Zwischenrahmen von einem Leiterplattentyp auf den anderen umzustellen, ist es lediglich notwendig, die Adapternadeln 15 entsprechend der anderen Schaltungskonfiguration anzuordnen und eine entsprechende Wrapverdrahtung vorzunehmen. Nach dem Wrapverdrahten und Bestücken mit Nadeln ist dieser Zwischenrahmen für einen neuen Leiterplattentyp einsatzbereit. Alle Grundelemente des Zwischenrahmens sind dadurch wieder verwendbar, so daß die "verlorenen" Kosten, die dem entsprechenden Leiterplattentyp zuzuordnen sind, gering bleiben.

In Fig. 5 ist der Ablauf des Arbeitsverfahrens bei Anwendung einer Adaptereinrichtung nach der Erfindung ersichtlich. Fig. 5a zeigt die Vorrichtung ohne Zwischenrahmen lediglich mit dem feststehenden Standardnadelfeld 8 und den dazugehörigen Adapternadeln 12 sowie der Andruckplatte 2. In Fig. 5b ist ein Arbeitsschritt dargestellt,

0062833

bei dem der Zwischenrahmen 1 bereits eingelegt ist.
In Fig. 5c ist der Zwischenrahmen 1 mit dem Standardnadelfeld 8 über die Wrapstifte 14 und die Adapternadeln
12 ·                 kontaktiert. In der darauffolgenden Darstellung 5d ist die Prüflingsaufnahme 6 bereits eingelegt und in der Fig. 5e ist der Zustand dargestellt, wie
er sich nach Einlegen der Prüflingsleiterplatte 7 ergibt.
Fig. 5f zeigt nunmehr den Endzustand. Die Prüflingsleiterplattenaufnahme ist in Pfeilrichtung gegen die Adaptiernadeln 15 des Zwischenrahmens gedrückt worden, so daß nummehr die Kontaktierung zwischen den Meßpunkten auf der
Prüflingsleiterplatte 7 und dem Prüfautomaten hergestellt
ist, die Prüfung kann nunmehr beginnen. Die Kontaktierung
sowohl mit dem Standardnadelfeld als auch mit den Leiterplattenprüfpunkten erfolgt durch Ausführung der entsprechenden Arbeitshube selbsttätig.

5 Figuren
2 Patentansprüche

Patentansprüche

1. Adaptiereinrichtung zur elektrischen Verdrahtungsprüfung von unbestückten Leiterplatten mit einem die
Kontaktelemente tragenden Adapter und einer gegen den
Adapter bewegbaren Leiterplattenaufnahme, d a d u r c h
g e k e n n z e i c h n e t , daß der Adapter aus einem
Zwischenrahmen (1) besteht, der zwischen einer Andruckplatte (2) und der Leiterplattenaufnahme (6) beweglich
angeordnet ist, daß mindestens auf einer Seite der Leiterplattenaufnahme ein feststehendes Standardnadelfeld (8)
angeordnet ist, das eine für die Prüfung unterschiedlicher
Leiterplattenkonfigurationen ausreichende Anzahl von Adapternadeln (12) enthät, an die die erforderlichen Prüfleitungen
angelegt sind, daß der Zwischenrahmen (1) aus einer Abdeckplatte
(3), einer Trägerplatte (4) und einer Führungsplatte (5)
besteht, daß doe Trägerplatte (4) in ihren Randbereichen in
festen Rastern angeordnete Stifte (14) enthält, die mit den
Adapternadeln (12) kontaktierbar sind, daß die Trägerplatte
(4) im Leiterplattenprüflingsbereich weitere in einem leiterplattenprüflingsbezogenen Raster angeordnete Stifte (15) aufweist, die mit in einer Führungsplatte (5) befestigten Prüflingsadapternadeln (13) verbunden sind, daß zwischen den
Stiften (14) für das Standardnadelfeld (8) und den Stiften
für den Prüflingsbereich eine für den speziellen Leiterplattenprüfling angepaßte Verdrahtung (10) vorgesehen ist,
daß die Abdeckplatte (3) den Anschlag für die Stifte (14,
15) auf der Verdrahtungsseite bildet und daß der Leiterplattenprüfling (7) auf der Leiterplattenprüflingsaufnahme
(6) befestigt ist.

2. Verfahren zur elektrischen Verdrahtungsprüfung von unbestückten Leiterplatten mit einer Adaptiereinrichtung nach
Anspruch 1, d a d u r c h g e k e n n z e i c h n e t,
daß in einem ersten Schritt die Andruckplatte (2) gegen den
Zwischenrahmen (1) gedrückt wird, so daß dessen seitlichen Stifte (14) mit den Adapternadeln (12) des Standardnadelfeldes (8) kontaktiert werden und daß in einem
zweiten Schritt durch eine entgegengesetzte Bewegung
die Leiterplattenprüflingsaufnahme (6) mit dem Leiterplattenprüfling (7) gegen die Spitzen der Prüflingsadapternadeln (13) gedrückt wird, und daß in einem
dritten Schritt die Funktionsprüfung des Leiterplattenprüflings über einen mit dem Standardnadelfeld (8)
verbundenen Prüfautomaten erfolgt.

FIG 1

FIG 2

FIG 3

FIG 4

FIG 5

Europäisches Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| Y | US - A - 4 232 928 (P.D. WICKERSHAM) <br> * Spalte 8, Zeile 28 bis Spalte 11, Zeile 46; Fig. 3 * <br> -- | 1 |
| Y | IBM TECHNICAL DISCLOSURE BULLETIN <br> Band 21, Nr. 2, April 1978, New York <br> R. REIS et al. "Mass Termination Test Probe Fixture" <br> Seiten 765 bis 766 <br> * Seiten 765 bis 766; Fig. 1, 2 * <br> ---- | 1 |

**KLASSIFIKATION DER ANMELDUNG (Int. Cl.³)**

G 01 R 1/073

G 01 R 31/28

H 01 R 11/18

**RECHERCHIERTE SACHGEBIETE (Int. Cl.³)**

G 01 R 1/073

G 01 R 31/28

H 01 R 11/18

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Grunden angeführtes Dokument

&: Mitglied der gleichen Patentfamilie, übereinstimmendes Dokument

| | Der vorliegende Recherchenbericht wurde für alle Patentansprüche erstellt | |
|---|---|---|
| **Recherchenort** <br> Berlin | **Abschlußdatum der Recherche** <br> 25-06-1982 | **Prüfer** <br> LEMMERICH |

EPA form 1503.1  06.78